Europäisches Patentamt

European Patent Office

Office européen des brevets

(11) Publication number: **0 178 133**
**B1**

(12) **EUROPEAN PATENT SPECIFICATION**

(45) Date of publication of patent specification: **27.12.90**

(21) Application number: **85307129.8**

(22) Date of filing: **04.10.85**

(51) Int. Cl.⁵: **H 01 L 29/20,** H 01 L 29/04,
H 01 L 29/80, H 01 L 27/10

(54) Semiconductor integrated circuit device.

(30) Priority: **08.10.84 JP 209876/84**
**11.07.85 JP 152861/85**
**09.08.85 JP 176752/85**

(43) Date of publication of application:
**16.04.86 Bulletin 86/16**

(45) Publication of the grant of the patent:
**27.12.90 Bulletin 90/52**

(84) Designated Contracting States:
**DE FR GB**

(56) References cited:
**DE-A-1 807 857**
**FR-A-2 454 183**

**PATENTS ABSTRACTS OF JAPAN, vol. 8, no.
190 (E-263)1627r, 31st August 1984; & JP-A-59
79 577 (FUJITSU K.K.) 08-05-1984**

**PATENTS ABSTRACTS OF JAPAN, vol. 7, no.
264 (E-212)1409r, 24th November 1983; &
JP-A-58 145 168 (FUJITSU K.K.) 29-08-1983**

(73) Proprietor: **FUJITSU LIMITED**
**1015, Kamikodanaka Nakahara-ku**
**Kawasaki-shi Kanagawa 211 (JP)**

(72) Inventor: **Onodera, Tsukasa**
**Fujitsuatsugi-ryo 3-10, Sakae-cho 2-chome**
**Atsugi-shi Kanagawa 243 (JP)**
Inventor: **Kawata, Haruo**
**202, Chokohaitsu 1540-8, Hase**
**Atsugi-shi Kanagawa 243 (JP)**
Inventor: **Futatsugi, Toshiro**
**Fujitsuatsugi-ryo 3-10, Sakae-cho 2-chome**
**Atsugi-shi Kanagawa 243 (JP)**

(74) Representative: **Rackham, Stephen Neil et al**
**GILL JENNINGS & EVERY 53-64 Chancery Lane**
**London WC2A 1HN (GB)**

(56) References cited:
**IEEE TRANSACTIONS ON ELECTRON DEVICES,
vol. ED-31, no. 10, October 1984, pages 1377-
1380, IEEE, New York, US; P.M. ASBECK et al.:
"Piezoelectric effects in GaAs FET's and their
role in orientation-dependent device
characteristics"**

Courier Press, Leamington Spa, England.

**Description**

The present invention relates to a semiconductor integrated circuit device. More particularly, it relates to a new and improved semiconductor integrated circuit (IC) device wherein a plurality of field effect transistors (FET's) are formed on a III—V group compound semiconductor wafer.

In microelectronics, mainly silicon semiconductor devices are used, and silicon transistor elements have been miniaturized to obtain a high speed operation and integrated density of the semiconductor device.

However, to realize a further improved operation speed than that obtained by the properties of silicon, a compound semiconductor integrated circuit device using gallium arsenide (GaAs), which has an electron mobility (drift velocity) remarkably larger than that of silicon, has been developed.

The present inventors have found that, in the III—V group compound, e.g., GaAs, semiconductor, the gate threshold voltage ($V_{th}$), K-value, and piezoelectric polarization due to stress have a relationship to the material and thickness of an insulating layer formed on a gate electrode, and to the crystal surface and zone axis of a semiconductor substrate.

A primary object of the present invention is to provide a III—V group compound semiconductor integrated circuit device wherein a threshold voltage does not substantially depend on the thickness of an insulating layer.

A further object of the present invention is to provide a III—V group compound semiconductor integrated circuit device wherein a carrier drift velocity in a channel area is increased.

A still further object of the present invention is to provide a III—V group compound semiconductor integrated circuit device wherein said mutual conductance (gm) is increased due to a piezoelectric effect.

FR—A—2454 183 discloses a semiconductor field effect transitor structure in which an oxide layer is formed on a III—V compound semiconductor substrate having a (110) crystalline orientation.

According to the present invention a semiconductor integrated circuit device comprises a plurality of field effect transistors formed on a (110) crystal surface of a III—V group compound semiconductor substrate having a zinc blende type crystal structure, a source and drain of the field effect transistors being formed in a direction such that the direction of a drain current flowing between said source and drain is <001> or <1$\bar{1}$0>.

Particular examples will now be described with reference to the drawings; in which:

Figure 1 is a schematic cross-sectional view explaining a conventional FET;

Figure 2 is a cross-sectional view of a piezoelectric charge distribution of a conventional FET;

Figure 3 is a graph of a conventional relationship between gate threshold voltage ($V_{th}$) and gate length (Lg) in an FET;

Figure 4 is a view explaining the direction of a drain current ($I_{DS}$) according to the present invention;

Figure 5 is a graph of a relationship between a gate threshold voltage ($V_{th}$) and a thickness of an insulating layer;

Figure 6 is a graph of a relationship between a gate threshold voltage ($V_{th}$) and gate length (Lg) for three different directions of the drain current ($I_{DS}$) according to the present invention;

Figure 7 is a graph of a relationship between a K-value and gate length (Lg) for three different directions of the drain current ($I_{DS}$) according to the present invention;

Figure 8 is a cross-sectional view of a piezoelectric charge distribution according to the present invention;

Figure 9 is a view of an energy band;

Figure 10 is a graph of a relationship between the gate threshold voltage ($V_{th}$) and an angle formed by line vertical to the [1$\bar{1}$0] surface and drain current according to the present invention; and

Fig. 11A to 11D are views explaining a process for making an embodiment of the present invention.

Before describing the preferred embodiments of the present invention, a conventional device will be explained.

An FET, particularly a Schottky barrier type FET, hereinafter referred to as MES FET, conventionally uses a III—V group compound semiconductor such as GaAs.

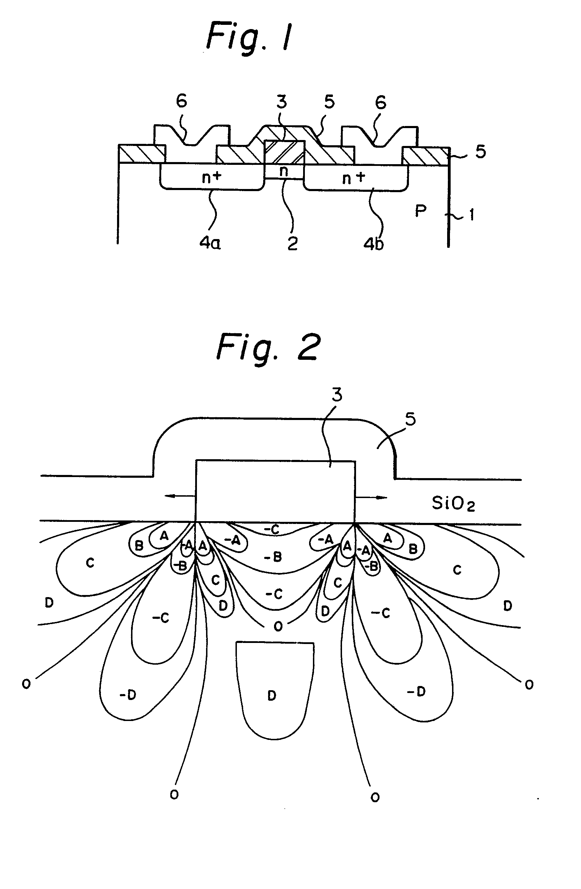

Figure 1 shows a schematic cross-sectional area explaining a conventional FET.

As shown in Fig. 1, in a semi-insulating GaAs substrate 1, an n channel layer 2 is formed by, for example, an ion-implantation process, and a gate electrode 3 is provided on the n channel layer 2 in Schottky-contact thereto.

$n^+$ type source and drain regions 4a and 4b are formed by an ion-implantation process using the gate electrode 3 as a mask. An insulating layer 5 is then formed on the substrate 1 and gate electrode 3, and source and drain electrodes 6 are provided so that they are in contact with the $n^+$ type source and drain regions 4a and 4b.

By using GaAs as the material of the substrate, as explained above, the electron mobility μ is increased from 1500 cm²/Vsec to 4000 cm²/Vsec.

To obtain high speed operation and a high integration density in the structure of the FET, the FET element is miniaturized and a gate length (Lg) is shortened.

However, with the shortening of the Lg, short channel effect, such as the gate threshold voltage ($V_{th}$) and the K-value are largely deviated from a desired value become significant. The deviation from the desired value is dependent on the direction of the gate or drain current, with respect to the zone axis or crystal surface of the semi-insulating GaAs substrate. One cause of this short channel effect is the piezoelectric polarization effect generated by an insulating layer on the GaAs substrate.

The piezoelectric polarization results from stress given to a semiconductor substrate by the insulating layer.

Figure 2 shows a cross-sectional view of a piezoelectric charge distribution of a conventional FET.

The piezoelectric charge distribution causes expansion or contraction of the Schottky gate depletion layer, due to a change of carrier distribution in the channel layer (see, for example, P. M. Asbeck et al.; IEEE Transaction Electron Devices, Vol. ED—31, No. 10, Oct. 1984).

The piezoelectric charge is generated because of asymmetry of the crystal in the III—V group compound semiconductor, as shown in Fig. 2, and has an effect on the gate threshold voltage.

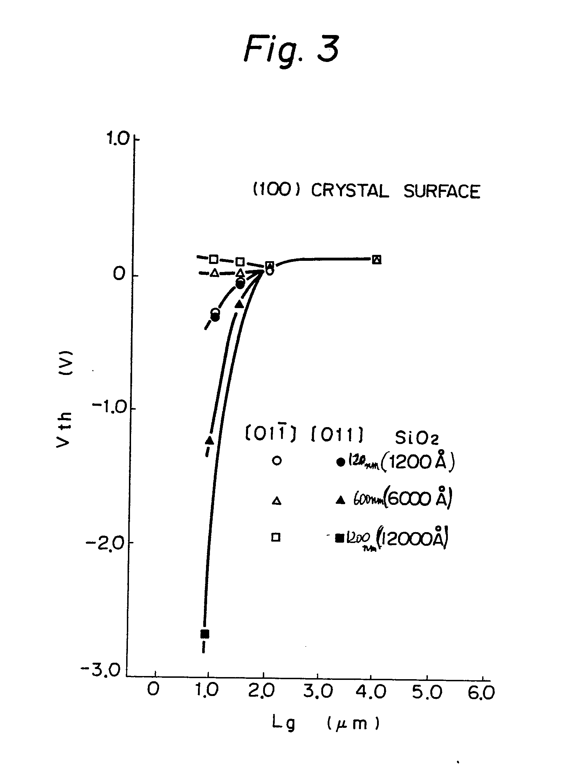

Figure 3 shows a graph of a conventional relationship between the gate threshold voltage ($V_{th}$) and a gate length (Lg) in an FET.

In Fig. 3, a silicon dioxide ($SiO_2$) insulating layer and a (100) crystal surface of a GaAs single crystalline substrate was used. Gates having different gate width directions, i.e., [1$\bar{1}$0] and [110], were used, and three different thicknesses of $SiO_2$, i.e., 120 nm, 600 nm and 1200 nm (1200 Å), 6000 Å and 12000 Å), were used.

In the [01$\bar{1}$] direction, and [011] direction perpendicular to the [01$\bar{1}$] direction, the directions of the deviation of $V_{th}$ are positive and negative respectively, and the amount of deviation thereof is very large as shown in Fig. 3. In this specification the marks ( ), < > and [ ] denote crystal surface, zone axis direction, and crystal direction, respectively.

The preferred embodiments of the present invention will now be described.

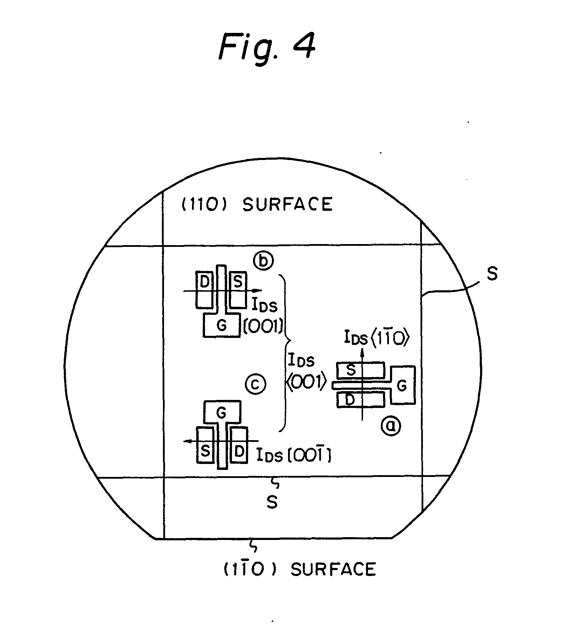

Figure 4 shows a view explaining the direction of the drain current ($I_{DS}$) according to the present invention.

Figure 4 shows a (110) surface of a GaAs substrate. The (1$\bar{1}$0) surface of Fig. 4 is a cleavage surface perpendicular to the (110) surface. Three types of FET are shown in the (110) surface of the GaAs substrate. These FET's have different $I_{DS}$ directions, i.e., ⓐ <1$\bar{1}$0> direction, ⓑ [001] direction, and ⓒ [00$\bar{1}$] direction parallel to the [001] direction. The <1$\bar{1}$0> direction is perpendicular to both the [001] and [00$\bar{1}$] directions.

Scribelines S in Fig. 4 are parallel or perpendicular to the direction of the gate width. In such an arrangement of FET's on the (110) surface of the GaAs substrate, the properties of the FET can be improved, as explained below.

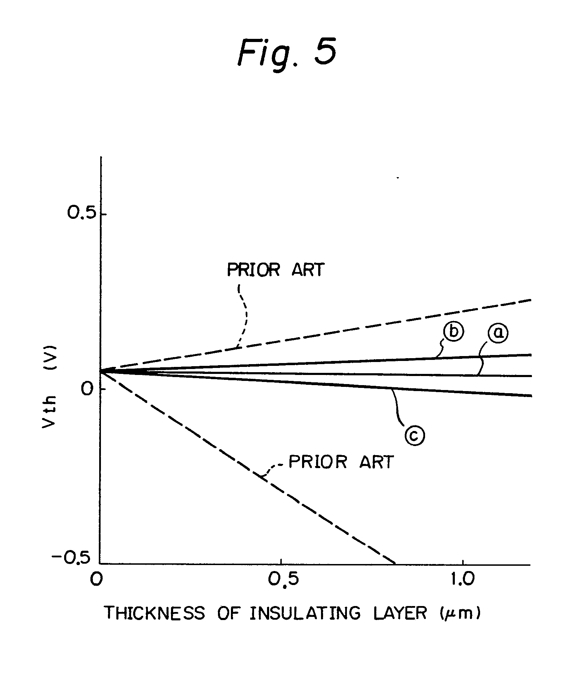

Figure 5 shows a graph of a relationship between a gate threshold voltage ($V_{th}$) and the thickness of the insulating layer.

As shown in Fig. 5, the $V_{th}$ of lines ⓐ,ⓑ and ⓒ substantially have no dependency on the thickness of the insulating layer. However, $V_{th}$ of the prior art shown by broken lines are remarkably dependent on the thickness of the insulating layer. These ⓐ,ⓑ and ⓒ lines correspond to those shown in Fig. 4. Gate length (Lg) of a FET used in Fig. 5 is 1.4 μm.

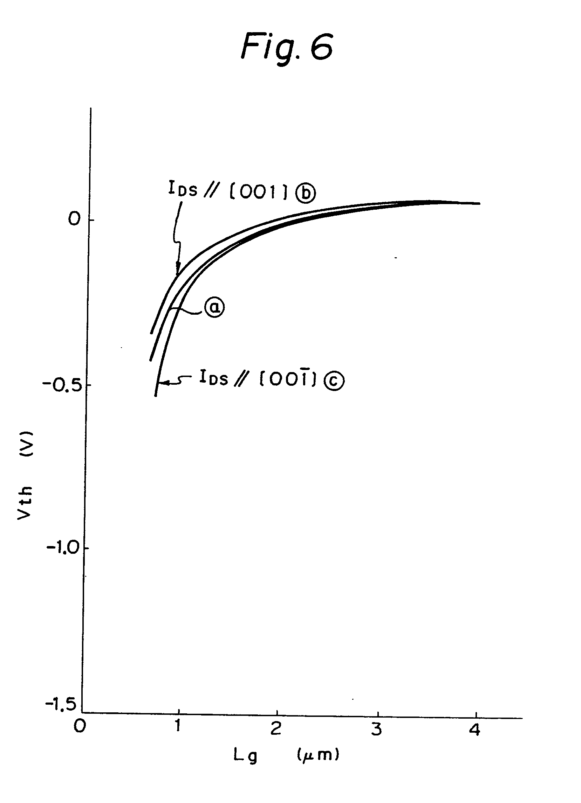

Figure 6 shows a graph of a relationship between a gate threshold voltage ($V_{th}$) and a gate length (Lg) in three different directions of the drain current ($I_{DS}$), according to the present invention.

As shown in Fig. 6, $V_{th}$ changes in lines ⓐ,ⓑ, and ⓒ are approximately similar. These ⓐ,ⓑ, and ⓒ curves correspond to those shown in Fig. 4.

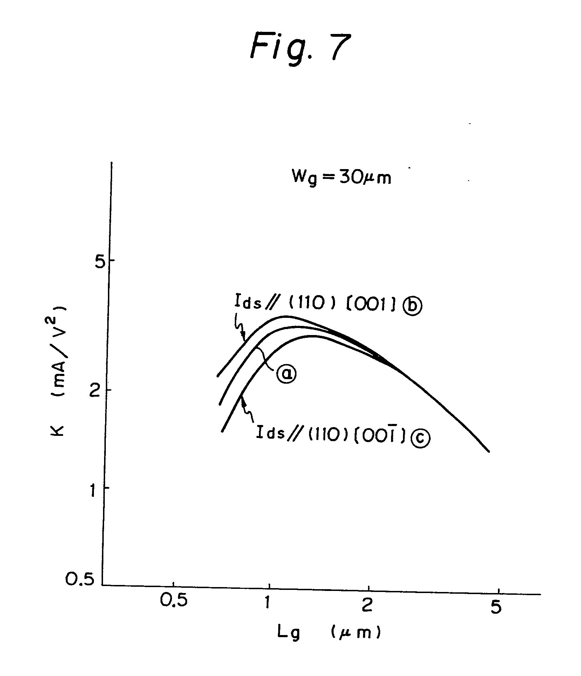

Figure 7 shows a graph of a relationship between a K-value and gate length [Lg] in three different directions of drain current ($I_{DS}$) according to the present invention.

As shown in Fig. 7, the K-value of ⓑ is larger than that of ⓐ and ⓒ. In this case, FETs having a gate width (Wg) of 30 μm were used. The K-value corresponds to the mutual conductance (gm).

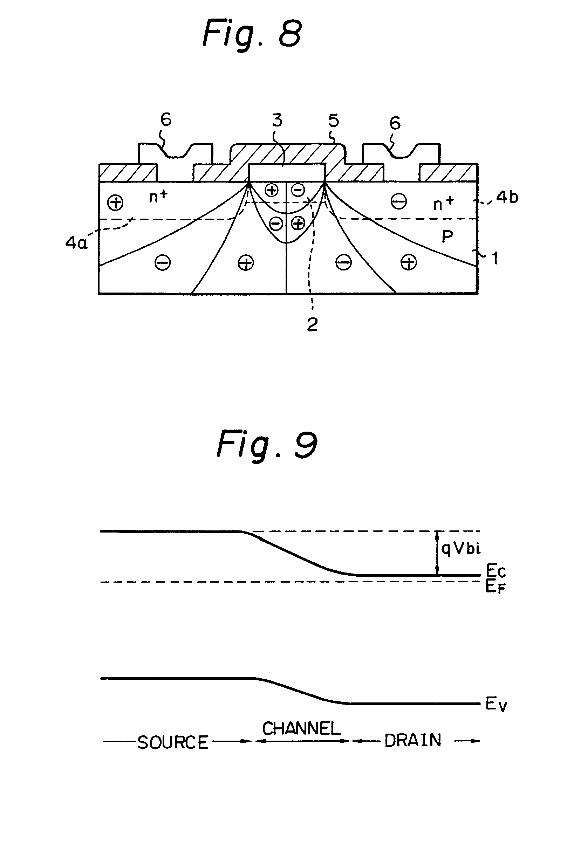

In the case of ⓑ, the direction of the drain current is [001], as explained above, and the gate width direction is [1$\bar{1}$0]. The present inventor found that, in such an [1$\bar{1}$0] direction of the gate width, both side regions of a gate electrode, i.e., a source and drain region, are subjected to a piezoelectric charge distribution having opposing signs, such as ⊕ and ⊖, as shown in Fig. 8.

The reference numbers for parts shown in Fig. 8 correspond to those shown in Fig. 1.

Since the $SiO_2$ layer used as the insulating layer 5 exerts a tensile force on the gate 3, the polarization distribution is different at the left and right sides of the gate 3. The source region 4a and drain region 4b have a positive charge and negative charge, respectively. In this configuration, the signs of piezoelectric charge nearby the channel conductance path, which is formed near the bottom of n layer, are negative at source side, and positive at drain side, respectively. Thus the drain current $I_{DS}$ [001] in the case of ⓑ was selected so that the piezoelectric polarization distribution as shown in Fig. 8 is given, whereby an equilibrium energy band structure with a constant bias of $qV_{bi}$ in the source region can be obtained, as shown in Figure 9. This constant bias of $qV_{bi}$ strengthens the electric field acting on the carriers, resulting in an increase in the carrier or electron drift velocity and consequently strengthens their mutual conductance. Such piezoelectric charge distribution shown in Fig. 8 cannot be obtained in silicon substrates. When a $Si_3N_4$ layer having a compression force to the substrate 1 is used as the insulating layer 5 the polarity is reversed to that of the $SiO_2$ layer. Namely the signs ⊕ and ⊖ in Fig. 8 are changed to signs ⊖ and ⊕ respectively. Increase of K-value in accordance with the inversion of the signs for the $Si_3N_4$ layer occurs in a case where the direction of the drain current is [00$\bar{1}$].

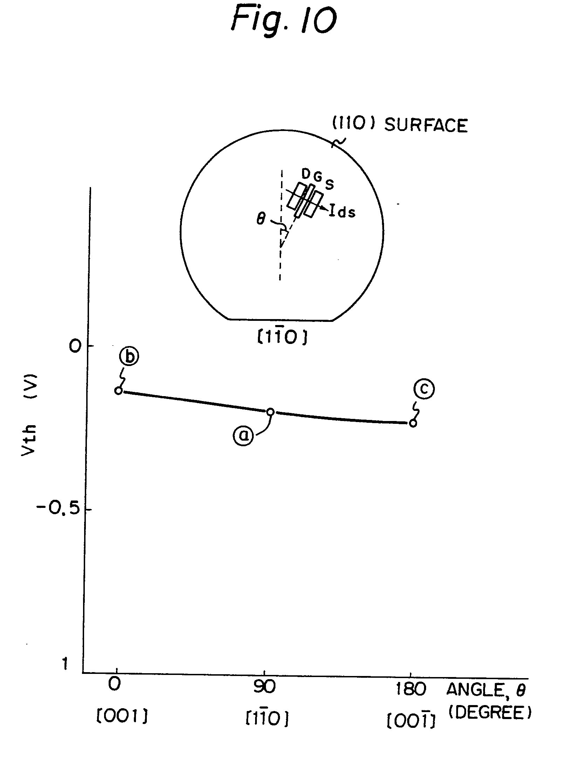

Figure 10 is a graph of a relationship between the gate threshold voltage ($V_{th}$) and an angle θ, formed by a vertical line from the [1$\bar{1}$0] surface, and a gate current according to the present invention.

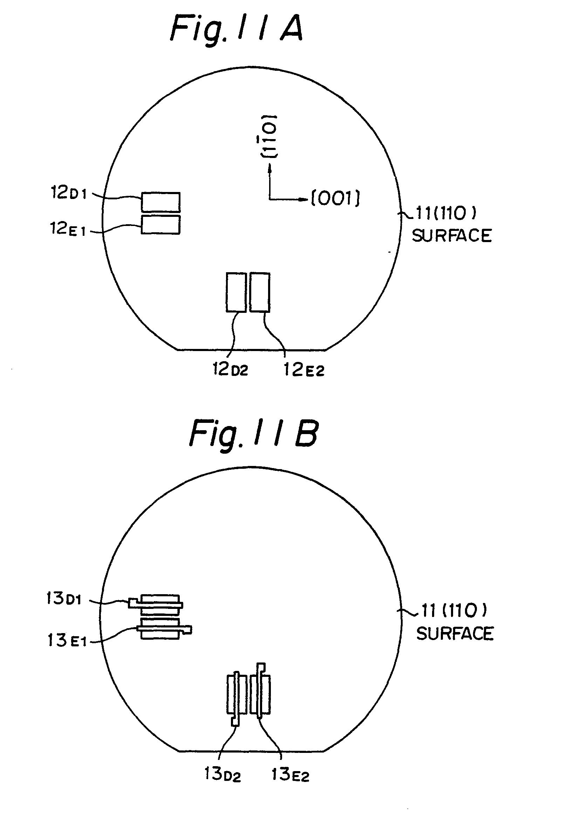

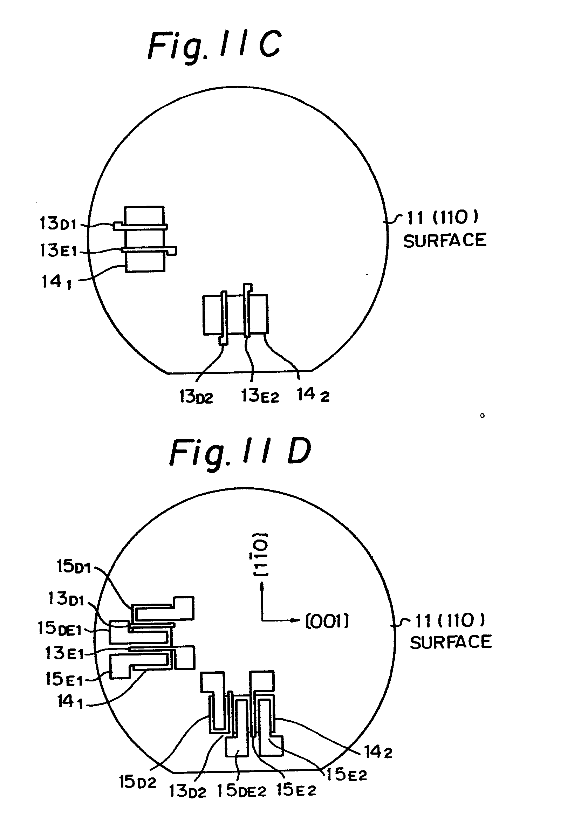

As shown in Fig. 10 even though the angle θ is changed from 0 to 180 degrees, the $V_{th}$ is little deviated. The symbols ⓐ,ⓑ, and ⓒ in Fig. 11 correspond to the lines shown in Fig. 4. $SiO_2$ was

used as an insulating layer, and the gate length was 1 μm. As explained in Fig. 8, when a $SiO_2$ layer having a tensile force is used the K-value is increased as shown as ⓑ in a case where the direction of the drain current is [00$\bar{1}$]. On the other hand, when a $Si_3N_4$ layer having a compression force is used the K-value is increase in a case where the direction of the drain current is [00$\bar{1}$], namely, in a case of ⓑ. Thus, in a case of $Si_3N_4$ layer, the inclination degree of the line in Fig. 10 is inverted.

Figures 11A to 11D are views explaining a process of an embodiment according to the present invention.

In this process inverters consisting of enhancement mode (E) and depletion mode (D) MES FET's are formed on a (110) surface of a semi-insulating GaAs substrate.

An inverter having D1 and E1 has a [001] gate direction and an inverter having D2 and E2 has a [1$\bar{1}$0] gate direction.

As shown in Fig. 11A, an n type channel region is formed in the (110) surface of a semi-insulating GaAs substrate 11 by an ion-implantation process at an energy of 59 KeV and $1.7 \times 10^{12}$ cm$^{-2}$ dosage in the D mode channel region, i.e., 12D1 and 12D2 and an energy of 59 keV and $0.9 \times 10^{12}$ cm$^{-2}$ dosage in the E mode channel region, i.e., 12E1 and 12E2. Then a protecting film such as aluminum nitride (AlN) (not shown) is formed over the substrate 1. An activating heat treatment is then carried out for 15 minutes at a temperature of 850°C.

Then, as shown in Fig. 11B for example, a tungsten silicide ($W_5Si_3$) layer having a thickness of 400 nm is formed on the obtained structure by a sputtering process and patterned to form each electrode 13 having a gate length of 1 μm.

Then, as shown in Fig. 11C, an n$^+$ type source and drain 14 are formed on the obtained structure by a silicon ion injecting process using an energy of 175 keV and dosage of $1.7 \times 10^{13}$ cm$^{-2}$, and by an activating heat treatment for 10 minutes.

Then, as shown in Fig. 11D, a silicon nitride (SiNx) layer (not shown) having a thickness of 500 μm is formed over the obtained structure by, for example, a plasma-enhanced chemical vapour deposition process. Then, openings are formed in the SiNx layer over the n$^+$ type source and drain regions 14 to form AuGe/Au source and drain electrodes 15 having a thickness of 250 nm by a vapour deposition process.

The thus, produced MES FET elements having a D and E mode, respectively, have only a small difference in $V_{th}$, e.g., about 10 mV, and thus can be used equivalently.

In the present invention as the III—V group compound, semiconductor having a zinc blende type crystal structure In P can be also used instead of GaAs.

## Claims

1. A semiconductor integrated circuit device comprising a plurality of field effect transistors formed on a (110) crystal surface of a III—V group compound semiconductor substrate having a zinc blende type crystal structure, a source and drain of the field effect transistors being formed in a direction such that the direction of a drain current flowing between said source and drain is <001> or <1$\bar{1}$0>.

2. A semiconductor integrated circuit device according to claim 1, wherein an insulating layer having a tensile force against said semiconductor is formed over the field effect transistor and the source and drain are positioned so that the direction of the drain current is [001].

3. A semiconductor integrated circuit device according to claim 1, wherein an insulating layer having a compression force against the semiconductor substrate is formed over the field effect transistor and the source and drain are positioned so that the direction of the drain current is [00$\bar{1}$].

4. A semiconductor integrated circuit device according to claim 1, wherein an insulating layer having a tensile force against said semiconductor is formed over the field effect transistor and the source and drain are positioned so that the direction of the drain current is [110].

5. A semiconductor integrated circuit device according to claim 1, wherein an insulating layer having a compression force against the semiconductor substrate is formed over the field effect transistor and the source and drain are positioned so that the direction of the drain current is [1$\bar{1}$0].

6. A semiconductor integrated circuit device according to claim 2, 3, 4 or 5, wherein a Schottky contact gate electrode is provided on the semiconductor substrate, a conductive type source and drain are respectively provided on the semiconductor substrate with respect to the gate electrode, and said insulating layer is formed on the source and drain in the semiconductor substrate and on the gate electrode.

## Patentansprüche

1. Integrierte Halbleiterschaltungsvorrichtung mit einer Vielzahl von Feldeffekttransistoren, die auf einer (110)-Kristalloberfläche eines Verbindungshalbleitersubstrates der III—V-Gruppe gebildet sind, welches eine Zinkblende-Typ-Kristallstruktur hat, wobei eine Source und ein Drain der Feldeffekttransistoren in einer Richtung so gebildet sind, daß die Richtung des Drainstromes, der zwischen der genanten Source und dem Drain fließt, <001> oder <1$\bar{1}$0> ist.

2. Integrierte Halbleiterschaltungsvorrichtung nach Anspruch 1, bei der eine isolierende Schicht, die eine Zugkraft auf den genannten Halbleiter ausübt, über dem Feldeffekttransistor gebildet ist und die Source und das Drain so positioniert sind, daß die Richtung des Drainstromes [001] ist.

3. Integrierte Halbleiterschaltungsvorrichtung nach Anspruch 1, bei der eine isolierende Schicht, die eine Kompressionskraft auf das Halbleitersubstrat ausübt, über dem Feldeffekttransistor gebildet ist und die Source und das Drain so positioniert sind, daß die Richtung des Drainstromes [00$\bar{1}$] ist.

4. Integrierte Halbleiterschaltungsvorrichtung nach Anspruch 1, bei der eine isolierende Schicht, die eine Zugkraft auf den genannten Halbleiter ausübt, über dem Feldeffekttransistor gebildet ist und die Source und das Drain so positioniert sind, daß die Richtung des Drainstromes [110] ist.

5. Integrierte Halbleiterschaltungsvorrichtung nach Anspruch 1, bei der eine isolierende Schicht, die eine Druckkraft auf das Halbleitersubstrat ausübt, über dem Feldeffekttransistor gebildet ist und die Source und das Drain so positioniert sind, daß die Richtung des Drainstromes [1$\bar{1}$0] ist.

6. Integrierte Halbleiterschaltungsvorrichtung nach Anspruch 2, 3, 4 oder 5, bei der eine Schottky-Kontaktgateelektrode auf dem Halbleitersubstrat vorgesehen ist, eine Source bzw. ein Drain vom leitenden Typ auf dem Halbleitersubstrat in Bezug auf die Gateelektrode vorgesehen ist und die genannte isolierende Schicht auf der Source und dem Drain in dem Halbleitersubstrat und auf der Gateelektrode gebildet ist.

**Revendications**

1. Dispositif semi-conducteur à circuit intégré comprenant une pluralité de transistors à effet de champ formés sur une surface cristalline (110) d'un substrat semi-conducteur à base de composé des groupes III—V ayant une structure cristalline de type blende de zinc, une source et un drain des transistors à effet de champ étant formés dans une direction telle que la direction d'un courant de drain circulant entre ladite source et ledit drain soit <001> ou <1$\bar{1}$0>.

2. Dispositif semi-conducteur à circuit intégré selon la revendication 1, dans lequel une couche isolante exerçant une force de traction sur ledit semi-conducteur est formée sur le transistor à effet de champ et la source et le drain sont positionnés de telle façon que la direction du courant de drain soit [001].

3. Dispositif semi-conducteur à circuit intégré selon la revendication 1, dans lequel une couche isolante exerçant une force de compression sur le substrat semi-conducteur est formée sur le transistor à effet de champ, et la source et le drain sont positionnés de telle façon que la direction du courant de drain soit [00$\bar{1}$].

4. Dispositif semi-conducteur à circuit intégré selon la revendication 1, dans lequel une couche isolante exerçant une force de traction sur ledit semi-conducteur est formée sur le transistor à effet de champ, et la source et le drain sont positionnés de telle façon que la direction du courant de drain soit [110].

5. Dispositif semi-conducteur à circuit intégré selon la revendication 1, dans lequel une couche isolante exerçant une force de compression sur le substrat semi-conducteur est formée sur le transistor à effet de champ, et la source et le drain sont positionnés de telle façon que la direction du courant de drain soit [1$\bar{1}$0].

6. Dispositif semi-conducteur à circuit intégré selon la revendication 2, 3, 4 ou 5, dans lequel une électrode de grille à contact de Schottky est disposée sur le substrat semi-conducteur, une source et un drain de type conducteur sont prévus respectivement sur le substrat semi-conducteur par rapport à l'électrode de grille, et ladite couche isolante est formée sur la source et le drain dans le substrat semi-conducteur et sur l'électrode de grille.

## Fig. 1

## Fig. 2

1

# Fig. 3

# Fig. 4

# Fig. 5

## Fig. 6

$I_{DS} \parallel (001)$ ⓑ

ⓐ

$I_{DS} \parallel (00\bar{1})$ ©

Vth (V)

Lg (μm)

# Fig. 7

## Fig. 8

## Fig. 9

# Fig. 10

*Fig. I I A*

12D1

12E1

[1̄10]

[001]

11(110)
SURFACE

12D2          12E2

*Fig. I I B*

13D1

13E1

11(110)
SURFACE

13D2      13E2

## Fig. 11 C

13D1

13E1

14₁

11 (110)
SURFACE

13D2    13E2   14₂

## Fig. 11 D

15D1

13D1

15DE1

13E1

15E1

14₁

[1̄10]

[001]

11 (110)
SURFACE

14₂

15E2

15D2   13D2  15DE2  15E2

10